(19) Europäisches Patentamt
European Patent Office
Office européen des brevets

(11) **EP 4 382 930 A1**

(12) **DEMANDE DE BREVET EUROPEEN**

(43) Date de publication:
**12.06.2024 Bulletin 2024/24**

(21) Numéro de dépôt: **23210009.9**

(22) Date de dépôt: **15.11.2023**

(51) Classification Internationale des Brevets (IPC):
*G01R 31/36* (2020.01)   *H02J 7/00* (2006.01)
*B60L 58/12* (2019.01)   *H01M 10/48* (2006.01)
*B60L 58/24* (2019.01)   *H01M 10/625* (2014.01)

(52) Classification Coopérative des Brevets (CPC):
**H02J 7/0048; B60L 58/12; G01R 31/3647; H01M 10/486;** B60L 58/24; H01M 10/625; H01M 2220/20; H02J 7/007194

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **08.12.2022 FR 2212947**

(71) Demandeur: **Commissariat à l'énergie atomique et aux énergies alternatives**
**75015 Paris (FR)**

(72) Inventeurs:
• **KAROUI HENCHIRI, Fathia**
  **38054 Grenoble cedex 9 (FR)**
• **MONTARU, Maxime**
  **38054 Grenoble cedex 9 (FR)**
• **VINIT, Laurent**
  **38054 Grenoble cedex 9 (FR)**

(74) Mandataire: **INNOV-GROUP**
**310, avenue Berthelot**
**69372 Lyon Cedex 08 (FR)**

(54) **PROCÉDÉ DE GESTION D'UNE BATTERIE**

(57) L'invention concerne un procédé de gestion d'une batterie, mis en oeuvre à l'aide d'un système de gestion, ladite batterie étant destinée à suivre un profil de mission (PM) en puissance ou en courant débutant à partir d'un instant t1 déterminé, postérieur à un instant initial t0, le procédé consistant à :
- Déterminer un état de fonction (SOF) théorique de la batterie à l'instant t1, ladite batterie pouvant être dans un état fonctionnel lorsqu'elle est capable de remplir le profil de mission (PM) ou dans un état non-fonctionnel lorsqu'elle n'est pas capable de remplir le profil de mission (PM) à l'instant t1,
- Exécution d'une séquence auxiliaire (S_Aux) pour que la batterie soit en mesure d'effectuer le profil de mission lorsque la batterie est déterminée dans un état non fonctionnel à l'instant t1.

Fig. 1A

**Description**

**Domaine technique de l'invention**

La présente invention se rapporte à un procédé et à un système de gestion d'une batterie.

**Etat de la technique**

De manière connue, certains véhicules, qui utilisent des batteries rechargeables, par exemple de type Lithium-ion, disposent d'un système pour préchauffer leurs batteries et même pour les charger, avant leur mise en fonctionnement, ceci afin d'éviter tous risques de non-démarrage du véhicule. C'est le cas par exemple des bus électriques, de certains avions ou de certains camions électriques ou thermiques.

Le système est utilisé pendant les phases de parking pour maintenir les batteries à un état de charge suffisant et/ou à une température suffisante, ces deux paramètres influençant la capacité de la batterie à démarrer, après un arrêt.

A titre d'exemple, une puissance électrique élevée est nécessaire lors du démarrage d'un bus électrique. Pour certains camions qui effectuent de longs trajets, les batteries sont souvent utilisées pour des tâches auxiliaires (éclairage, chauffage, cuisine...).

Si le système n'est pas présent ou non activé, la mission (démarrage ou autres) peut ne pas être assuré. Et lorsque ce type de système doit être activé, cela engendre forcément une surconsommation de carburant et d'énergie.

La demande de brevet WO2022/189105A1 décrit une méthode de prédiction de l'état fonctionnel d'une batterie d'un véhicule électrique. Le document s'intéresse plus particulièrement au risque de mise en défaut de la batterie lorsque son état de charge est trop faible au démarrage du véhicule, par exemple suite à une durée de stationnement trop longue dans des conditions atmosphériques défavorables.

Le but de l'invention est de proposer une solution pour faire en sorte que la batterie électrique puisse toujours remplir sa mission, en limitant si possible le recours à un préchauffage et/ou à une précharge, dans le but de consommer un minimum d'énergie.

**Exposé de l'invention**

Ce but est atteint par un procédé de gestion d'une batterie, mis en oeuvre à l'aide d'un système de gestion, ladite batterie étant destinée à suivre un profil de mission en puissance ou en courant débutant à partir d'un instant t1 déterminé, postérieur à un instant initial t0, ledit procédé comportant des étapes de :

- Détermination d'une valeur théorique de l'état de charge de la batterie à l'instant t1, à partir de l'état de charge initial de la batterie mesuré à l'instant t0 et de données théoriques de consommation de la batterie entre les instants t0 et t1
- Evaluation de la capacité de la batterie à remplir le profil de mission en état de charge audit instant t1, à partir de la valeur théorique de l'état de charge de la batterie à l'instant t1, et d'une valeur d'état de charge minimale à partir de laquelle le profil de mission peut être assuré,
- Détermination d'un état de fonction théorique de la batterie à l'instant t1, ladite batterie pouvant être dans un état fonctionnel lorsqu'elle est capable de remplir le profil de mission ou dans un état non-fonctionnel lorsqu'elle n'est pas capable de remplir le profil de mission à l'instant t1,
- Exécution d'une séquence auxiliaire pour que la batterie soit en mesure d'effectuer le profil de mission lorsque la batterie est déterminée dans un état non fonctionnel à l'instant t1,
- La séquence auxiliaire consistant à :

   ◦Evaluer la nécessité d'une action corrective à appliquer à la batterie pour l'exécution du profil de mission,
   ◦Déterminer l'action corrective à appliquer si celle-ci a été considérée comme nécessaire,

- Evaluation de la nécessité de l'application d'une action corrective à apporter à la batterie, consistant à comparer une valeur théorique d'état de charge de la batterie avec une valeur réelle mesurée à un instant t0' donné antérieur audit instant t1 et postérieur à t0.

De manière plus concrète, dans l'invention, lorsque l'on a constaté que la batterie était a priori dans un état non fonctionnel à l'instant t1, on réveille le BMS pour refaire une mesure de l'état de charge à t0' et on compare cette valeur avec celle qui avait été prédite. Et c'est en fonction de cette comparaison que l'on décide si l'action corrective doit être menée.

En revanche, la méthode décrite dans le document WO2022/189105A1 n'inclut pas la possibilité de ne pas mener l'action corrective s'il s'avère finalement que ce n'est pas nécessaire. Grâce à la solution de l'invention, il est ainsi possible d'économiser de l'énergie.

Selon une particularité, le procédé comporte des étapes de :

- Détermination de valeurs théoriques de la température ambiante entre les instants t0 et t1,
- Détermination de valeurs théoriques de la température de la batterie à l'instant t1, à partir des valeurs théoriques de la température ambiante,
- Détermination de l'état de charge minimum de la batterie nécessaire à la réalisation du profil de mission, en fonction de la température de la batterie.

Selon une autre particularité, le procédé comporte également une étape d'évaluation de la capacité de la batterie à remplir le profil de mission en température audit instant t1, à partir de la valeur théorique de la température de la batterie à l'instant t1, et d'une valeur de température minimale à partir de laquelle le profil de mission peut être assuré.

Selon une autre particularité, évaluer la nécessité de l'application d'une action corrective à apporter à la batterie comporte la comparaison d'une valeur théorique de température de la batterie avec une valeur réelle mesurée à un instant t0' donné antérieur audit instant t1 et postérieur à l'instant t0.

Selon une autre particularité, l'étape de détermination de valeurs théoriques de la température ambiante entre t0 et t1 est réalisée par acquisition de données sur un serveur distant.

Selon une autre particularité, le procédé comporte une étape de mise en veille du système de gestion entre l'instant t0 et l'instant t0'.

Selon une autre particularité, l'action corrective consiste en un préchauffage de la batterie et/ou en une charge de la batterie.

Selon une autre particularité, le procédé comporte une étape d'évaluation de l'application d'une action corrective de charge de la batterie, en tenant compte d'une variation, en fonction de la température, de l'état de charge minimum de la batterie nécessaire à la réalisation du profil de mission.

Selon une autre variante de réalisation, le procédé comporte :

- Une étape de détermination d'une courbe théorique de l'état de charge de la batterie sur une période temporelle postérieure à t0, à partir de l'état de charge initial de la batterie mesuré à l'instant t0 et des données théoriques de consommation de la batterie sur ladite période temporelle postérieure à t0,
- Une étape de détermination d'une courbe théorique de la température de la batterie sur ladite période temporelle postérieure à t0, à partir de la température initiale de la batterie mesurée à l'instant t0 et des valeurs théoriques de la température ambiante sur ladite période temporelle postérieure à t0,
- Une étape d'évaluation de la capacité de la batterie à remplir le profil de mission en état de charge sur ladite période temporelle, par comparaison de la courbe théorique d'état de charge avec une courbe minimale d'état de charge pour laquelle la batterie est apte à remplir le profil de mission, et/ou
- Une étape d'évaluation de la capacité de la batterie à remplir le profil de mission en température sur ladite période temporelle, par comparaison de la courbe théorique de la température de la batterie avec une courbe minimale de température pour laquelle la batterie est apte à remplir le profil de mission.

Selon une particularité, le procédé comporte une étape de détermination de la courbe minimale d'état de charge pour laquelle la batterie est apte à remplir le profil de mission à partir de ladite courbe théorique de température.

Selon une autre particularité, la séquence auxiliaire consiste à déterminer un ou plusieurs instants, autres que l'instant t1, auxquels la batterie sera capable de remplir le profil de mission.

L'invention concerne également un système de gestion d'une batterie, ladite batterie étant destinée à suivre un profil de mission en puissance ou en courant débutant à partir d'un instant t1 déterminé, postérieur à un instant initial t0, ledit système comportant :

- Un module de détermination d'une valeur théorique de l'état de charge de la batterie à l'instant t1, à partir de l'état de charge initial de la batterie mesuré à l'instant t0 et de données théoriques de consommation de la batterie entre les instants t0 et t1
- Un module d'évaluation de la capacité de la batterie à remplir le profil de mission en état de charge audit instant t1, à partir de la valeur théorique de l'état de charge de la batterie à l'instant t1, et d'une valeur d'état de charge minimale à partir de laquelle le profil de mission peut être assuré,
- Un module de détermination d'un état de fonction théorique de la batterie à l'instant t1, ladite batterie pouvant être dans un état fonctionnel lorsqu'elle est capable de remplir le profil de mission ou dans un état non-fonctionnel lorsqu'elle n'est pas capable de remplir le profil de mission à l'instant t1,
- Un module d'exécution d'une séquence auxiliaire pour que la batterie soit en mesure d'effectuer le profil de mission lorsque la batterie est déterminée dans un état non fonctionnel à l'instant t1,

- La séquence auxiliaire consistant à :

  ◦ Evaluer la nécessité d'une action corrective à appliquer à la batterie pour l'exécution du profil de mission,
  ◦ Déterminer l'action corrective à appliquer si celle-ci a été considérée comme nécessaire, et

- Pour évaluer la nécessité de l'application d'une action corrective à apporter à la batterie, le système comporte un module de comparaison d'une valeur théorique d'état de charge de la batterie avec une valeur réelle mesurée à un instant t0' donné antérieur audit instant t1 et postérieur à t0.

Selon une particularité, le système comporte :

- Un module de détermination des valeurs théoriques de la température ambiante entre les instants t0 et t1,
- Un module de détermination des valeurs théoriques de la température de la batterie à l'instant t1, à partir des valeurs théoriques de la température ambiante,
- Un module de détermination de l'état de charge minimum de la batterie nécessaire à la réalisation du profil de mission, en fonction de la température de la batterie.

Selon une autre particularité, le système comporte un module d'évaluation de la capacité de la batterie à remplir le profil de mission en température audit instant t1, à partir de la valeur théorique de la température de la batterie à l'instant t1, et d'une valeur de température minimale à partir de laquelle le profil de mission peut être assuré.

Selon une autre particularité, pour évaluer la nécessité de l'application d'une action corrective à apporter à la batterie, le système comporte un module de comparaison d'une valeur théorique de température de la batterie avec une valeur réelle mesurée à un instant t0' donné antérieur audit instant t1 et postérieur à l'instant t0.

Selon une autre particularité, le module de détermination de valeurs théoriques de la température ambiante entre t0 et t1 comporte des moyens d'acquisition de données sur un serveur distant.

Selon une autre particularité, le système comporte un module de mise en veille du système de gestion entre l'instant t0 et l'instant t0'.

Selon une autre particularité, l'action corrective consiste en un préchauffage de la batterie et/ou en une charge de la batterie.

Selon une autre particularité, le système comporte un module d'évaluation de l'application d'une action corrective de charge de la batterie, en tenant compte d'une variation, en fonction de la température, de l'état de charge minimum de la batterie nécessaire à la réalisation du profil de mission.

Selon une autre variante de réalisation, le système est caractérisé en ce qu'il comporte :

- Un module de détermination d'une courbe théorique de l'état de charge de la batterie sur une période temporelle postérieure à t0, à partir de l'état de charge initial de la batterie mesuré à l'instant t0 et des données théoriques de consommation de la batterie sur ladite période temporelle postérieure à t0,
- Un module de détermination d'une courbe théorique de la température de la batterie sur ladite période temporelle postérieure à t0, à partir de la température initiale de la batterie mesurée à l'instant t0 et des valeurs théoriques de la température ambiante sur ladite période temporelle postérieure à t0,
- Un module d'évaluation de la capacité de la batterie à remplir le profil de mission en état de charge sur ladite période temporelle, par comparaison de la courbe théorique d'état de charge avec une courbe minimale d'état de charge pour laquelle la batterie est apte à remplir le profil de mission, et/ou
- Un module d'évaluation de la capacité de la batterie à remplir le profil de mission en température sur ladite période temporelle, par comparaison de la courbe théorique de la température de la batterie avec une courbe minimale de température pour laquelle la batterie est apte à remplir le profil de mission.

Selon une particularité, le système comporte un module de détermination de la courbe minimale d'état de charge pour laquelle la batterie est apte à remplir le profil de mission à partir de ladite courbe théorique de température.

Selon une réalisation particulière, la séquence auxiliaire consiste à déterminer un ou plusieurs instants, autres que l'instant t1, auxquels la batterie sera capable de remplir le profil de mission.

**Brève description des figures**

D'autres caractéristiques et avantages vont apparaître dans la description détaillée qui suit faite en regard des dessins annexés dans lesquels :

- Les figures 1A et 1B illustrent le principe de fonctionnement de l'invention ;

- La figure 2 montre un diagramme illustrant la variation de température d'une batterie en fonction de la température ambiante au cours du temps ;
- La figure 3 montre l'effet de la température sur l'état de fonction de la batterie et illustre le principe de fonctionnement de l'invention ;

**Description détaillée d'au moins un mode de réalisation**

L'invention s'applique à au moins une batterie électrique, par exemple de type Lithium-Ion. Par batterie, on entend qu'elle peut comporter une ou plusieurs cellules, les cellules étant connectées en série et/ou parallèle. Le terme "batterie" englobe également ce que l'on appelle couramment "pack batterie", composé de plusieurs batteries.

Dans la suite de la description, l'expression "configuré à" ou "configuré pour" signifie que le système considéré dispose des moyens matériels et/ou logiciels pour mettre en oeuvre la fonction décrite.

L'invention vise ainsi à optimiser la gestion d'une batterie.

De manière connue, une unité de gestion est chargée de surveiller la batterie. Cette unité de gestion comporte ce qui est connu sous le nom de BMS (pour "Battery Management System" - désigné ci-après système BMS), destinée à la surveillance et à la gestion de la batterie, notamment de sa température, de son état de charge, du courant et de la puissance qu'elle délivre. Le système BMS est associé avec des capteurs chargés de mesurer les différentes grandeurs.

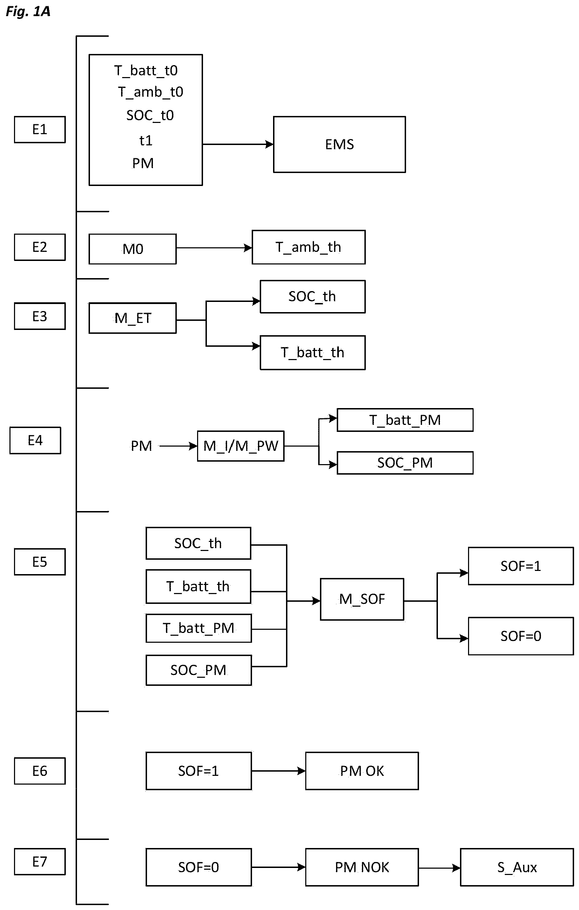

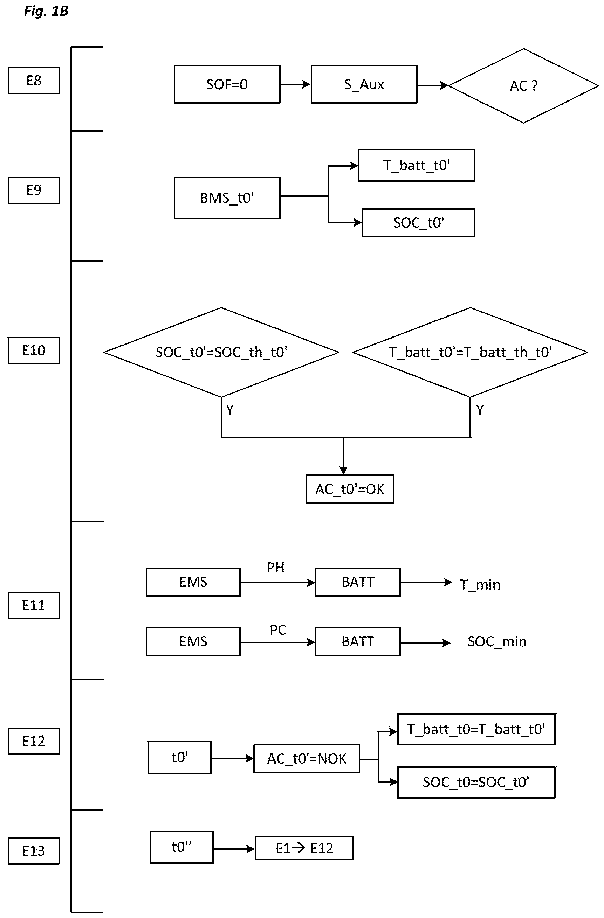

Dans le cadre de l'invention, l'unité de gestion peut également comporter un système de gestion de l'énergie de la batterie (EMS pour "Energy Management System" - désigné ci-après système EMS) chargé de déterminer la capacité de la batterie à suivre un profil de mission particulier, à un instant déterminé. Pour cela, le système EMS met en oeuvre le procédé de gestion tel que décrit ci-dessous, en liaison avec la figure 1A et la figure 1B. Le système met en oeuvre des modules logiciels et matériels adaptés à la mise en oeuvre du procédé de gestion.

Lorsque le véhicule électrique est arrêté, son système BMS est désactivé, les données normalement acquises par le système BMS ne sont donc plus disponibles. Le système EMS est donc exécuté juste avant l'arrêt du système BMS, à l'instant t0, de manière à pouvoir générer les données théoriques nécessaires pour maintenir une gestion de la batterie, et à pouvoir assurer au mieux un redémarrage ultérieur de la batterie, pour remplir une mission donnée.

Les différentes étapes du procédé conforme à l'invention sont référencées E1 à E13 et sont illustrées par la figure 1A et la figure 1B. Certaines de ces étapes peuvent être optionnelles.

E1 : Le système EMS s'appuie sur les données d'entrée suivantes, acquises alors que le système BMS est encore actif à t0 et avant que celui-ci soit mis en veille (le BMS est mis en veille après t0) :

- La température ambiante T_amb_t0 à l'instant t0 - elle est par exemple mesurée par un capteur et envoyée au système BMS ;
- La température de la batterie T_batt_t0 à l'instant t0 ;
- L'état de charge SOC_t0 de la batterie à l'instant t0 - il est déterminé par le système BMS ;
- L'instant t1 auquel la batterie est amenée à remplir la mission - il est par exemple saisi par l'utilisateur ;
- Le profil de mission PM que la batterie sera amenée à exécuter - il est par exemple renseigné par l'utilisateur ou pré-mémorisé dans le système BMS, parmi plusieurs profils de mission classiques connus ;

Ces données sont par exemple acquises par le système EMS, juste avant que le système BMS ne passe en état de veille.

Pour remplir cette mission, la batterie est sollicitée en décharge suivant un profil de mission, également connu. Le profil de mission PM peut consister en une forte variation du courant maximal délivré par la batterie à l'instant t1 ou en une variation de la puissance délivrée par la batterie à l'instant t1. Préférentiellement, la mission confiée est de nature courte et intensive, comme un besoin ponctuel de puissance élevée lié à un démarrage du véhicule.

Pour la suite de la description, on définit également :

- La période P0 allant de t0 à t1 ;
- La période P1 postérieure à t1 ;

E2 : Le système EMS est configuré pour acquérir des données de température ambiante T_amb_th sur la période P0, ainsi qu'optionnellement sur la période P1, pour une localité donnée. A titre d'exemple, ces données de température peuvent être obtenues par le système BMS (avant sa mise en veille) ou par le système EMS en se connectant à des serveurs météo M0. On obtient ainsi une courbe théorique de variation de la température ambiante.

E3 : Partant des données d'entrée, le système EMS est configuré pour exécuter un modèle électrothermique M_ET de la batterie pour déterminer :

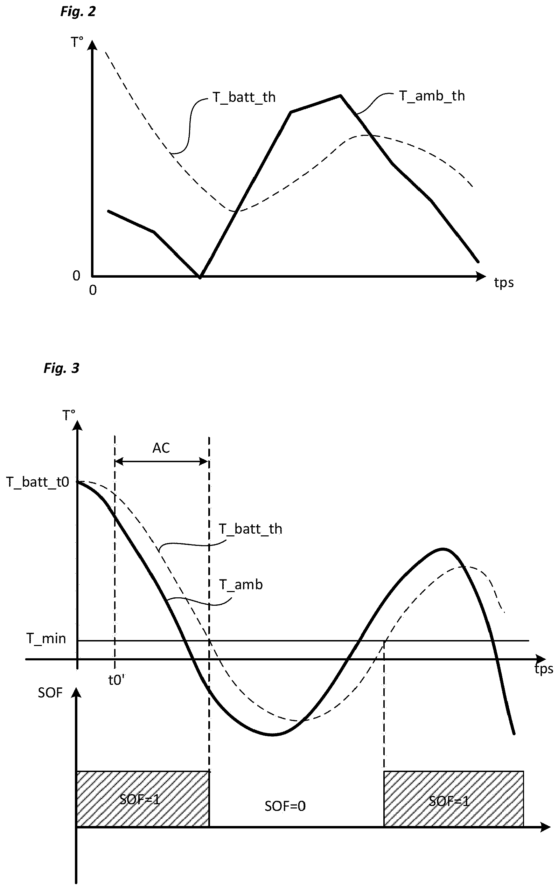

- Des valeurs théoriques de la température T_batt_th de la batterie à l'instant t1, et optionnellement sur la période P0 et sur la période P1 - ces valeurs théoriques sont estimées à partir de la température ambiante T_amb_t0, de la température T_batt_t0 de la batterie mesurée à t0, et de la courbe théorique de variation de la température ambiante déterminée à l'étape E2 pour la période P0 et optionnellement pour la période P1 - La figure 2 montre une courbe de variation de la température de la batterie T_batt_th en fonction de la variation de la température ambiante T_amb_th estimée ;
- Des valeurs théoriques de l'état de charge SOC_th de la batterie à l'instant t1, et optionnellement sur la période P0 et sur la période P1 - ces valeurs théoriques sont estimées à partir de l'état de charge SOC_t0 de la batterie obtenue à l'instant t0 et d'une estimation de la consommation de la batterie sur la période P0 et optionnellement sur la période P1, cette estimation étant réalisée par la connaissance du profil de mission PM que la batterie va être amenée à suivre. La simulation par pas de temps permet également de prendre en compte l'effet d'éventuelles sous-tirage sur la batterie (ex. alimentation d'auxiliaires) durant la période P0 ;
- Eventuellement, des valeurs théoriques de l'état d'énergie de la batterie, si l'énergie totale disponible est connue ;

De manière connue, un modèle électrothermique M_ET permet de simuler différents courants et puissances de charge/décharge à différentes températures en prenant en compte la dispersion des résistances et des capacités. Il est modulable par rapport à l'architecture électrique et géométrique de la batterie.

A titre d'exemple non limitatif, la partie électrique du modèle consiste en un modèle multi-cellules avec une source de tension (OCV : open circuit voltage) et une résistance pour chaque cellule. Ainsi la tension de chaque cellule U est liée au courant I par l'équation U=OCV+R I

Le modèle thermique est basé quant à lui sur des équations de génération de la chaleur et d'échanges thermiques avec l'air environnant. Il calcule la température par élément suivant son emplacement dans une zone du pack batterie.

L'équation d'échange de chaleur de la batterie s'exprime de la manière suivante :

$$mC_p \frac{dT\_batt\_th(t)}{dt} = \frac{d}{dt}(Q_{rev} + Q_{irrev}) - h \times (T\_batt\_th(t) - T\_amb\_th(t))$$

Avec :

- m la masse de la batterie ;
- Cp la capacité calorifique de la batterie - donnée d'entrée connue ;
- Qrev est la quantité de chaleur réversible générée par la batterie ;
- Qirrev est la quantité de chaleur irréversible générée par la batterie (liée à l'effet joule) $= R*I^2$;
- h le coefficient d'échange avec l'extérieur ;
- T_batt_th(t) la température de la batterie à tout instant t estimée à l'étape E3 ; on considérera principalement la température T_batt_th à l'instant t1 et optionnellement les températures T_batt_th sur la périodeP1 ;
- T_amb_th(t) la température ambiante à tout instant t estimée à l'étape E2 ; on considérera principalement la température T_amb_th sur la période P0 (pour en déduire la température à l'instant t1) et optionnellement la température T_amb_th sur la période P1 ;

Le modèle électrothermique M_ET permet d'obtenir les courants, tensions, températures et l'état de charge au niveau des différents éléments de la batterie (cellule, module, batterie, pack batterie...).

Un modèle électrothermique M_ET d'une batterie est par exemple décrit dans la publication *référencée "Gestion et modélisation électrothermique des batteries lithium-ion - David Allart - 26/03/2018- HAL Id: tel-01743791 - httos://tel.archives-ouvertes.fr/tel-01743791.*

E4 : Le système EMS dispose d'un modèle M_I/M_PW, exprimant un profil de puissance maximale et/ou un profil de courant maximal que la batterie va être capable de délivrer en fonction de la température et de l'état de charge de la batterie. Le système EMS peut ainsi en déduire, pour le profil de mission PM à remplir, à quelle température T_batt_PM et à quel état de charge SOC_PM la batterie devra se trouver pour être capable de remplir ce profil de mission PM.

Le choix de cartographier la puissance maximale ou le courant maximal dépend du profil de mission PM à simuler. Pour certaines applications, notamment celles utilisant des batteries au plomb lors d'un démarrage d'un véhicule, le profil de mission PM est généralement en courant, en lien avec le "Cold Cranking Current" (courant maximal fourni par la batterie à -18 C). Pour d'autres applications, le profil de mission PM est en puissance.

Optionnellement, les résultats de l'étape E4 peuvent être simplifiés pour ne considérer que l'état de charge SOC_PM dans la suite du processus de décision.

E5 : Partant des données d'entrée et des différents éléments obtenus aux étapes précédentes, le système EMS, via un module M_SOF adapté, est configuré pour déterminer l'état de fonction SOF de la batterie à l'instant t1, et optionnellement sur la période P1.

Autrement dit, il est amené à évaluer à l'instant t1 la capacité de la batterie à remplir le profil de mission PM en tenant compte de sa courbe théorique de variation de température T_batt_th et de sa courbe théorique de variation de son état de charge SOC_th.

Deux options d'évaluation sont possibles sur la base des données T_batt_PM et SOC_PM issues de l'étape E4.

- Une approche simple consiste à se limiter à l'évaluation de l'état de charge et vérifier que l'état de charge SOC_th à l'instant t1 est supérieur à la valeur minimum SOC_ min nécessaire pour effectuer la mission à l'instant t1.

- Alternativement, une deuxième approche, plus précise, basée sur les résultats obtenus à l'étape E4 nécessite :

  • Dans un premier temps de vérifier que la température T_batt_th à l'instant t1 est supérieure à une valeur de température minimale de la batterie nécessaire à l'exercice de la mission (référencée T_min) et qui correspond à la température T_batt_PM à l'instant t1 ;
  • Puis de vérifier que l'état de charge SOC_th à l'instant t1 est supérieur à la valeur minimum (référencée SOC_min) nécessaire pour effectuer la mission et qui correspond à l'état de charge SOC_ PM à l'instant t1.

Si la ou les conditions ci-dessus sont respectées, alors la batterie est jugée fonctionnelle pour répondre à la mission à l'instant t1. A défaut, la batterie est jugée non-fonctionnelle pour répondre à la mission à t1.

E6 : En considérant la deuxième approche ci-dessus, si la batterie est déterminée à l'instant t1 dans un état fonctionnel (SOF=1) à la fois en température et en état de charge, le profil de mission pourra être assuré à l'instant t1.

E7 : En considérant la deuxième approche ci-dessus, si la batterie est déterminée à l'instant t1 dans un état non-fonctionnel (SOF=0) en température et/ou en état de charge, le profil de mission ne pourra pas être assuré à l'instant t1.

Et lorsque la batterie est indiquée dans un état non fonctionnel à l'instant t1 auquel le profil de mission est censé être exécuté, le système EMS est alors configuré pour exécuter une séquence auxiliaire S_Aux pouvant permettre à la batterie d'assurer le profil de mission PM.

Deux variantes de réalisation peuvent être envisagées.
Dans une première variante, la séquence auxiliaire S_Aux exécutée peut consister à :

- Déterminer la nécessité d'une action corrective à appliquer à la batterie pour remplir le profil de mission à l'instant t1 ;
- Déterminer quelle est l'action corrective à mettre en place en cas de nécessité de cette action ;

Dans une deuxième variante, la séquence auxiliaire S_Aux peut consister à :

- Déterminer un ou plusieurs instants, autres que l'instant t1, auxquels la batterie sera capable de remplir le profil de mission ;

Les étapes E8 à E13 sont décrites ci-dessous pour la première variante de réalisation.

E8 : La batterie a été déterminée dans un état non fonctionnel à l'instant t1. Le système EMS lance alors la séquence auxiliaire S_Aux. Pour la première variante de réalisation, la séquence auxiliaire S_Aux consiste d'abord à déterminer si une action corrective AC à appliquer à la batterie est nécessaire pour que celle-ci puisse remplir le profil de mission PM.

E9 : Pour déterminer si une action corrective AC est nécessaire, le système EMS est configuré pour réveiller le système BMS, afin que celui-ci puisse à nouveau acquérir des valeurs réelles de température et d'état de charge, référencées T_batt_t0', SOC_t0'. Le système BMS est réveillé à un instant t0', postérieur à l'instant t0 et antérieur à l'instant t1, de manière à pouvoir anticiper l'exécution du profil de mission par une ou des éventuelles actions correctives.

Le système BMS est réveillé à l'instant t0' (BMS_t0' sur la figure 1B) uniquement si on prédit un besoin d'action corrective AC pour répondre au profil de mission PM à l'instant t1.

E10 : Après réveil du système BMS, le système EMS compare les valeurs théoriques de température T_batt_th_t0' et d'état de charge SOC_th_t0' déterminées (à l'aide du modèle électrothermique M_ET à l'étape E3) à l'instant t0' avec les valeurs réelles T_batt_t0', SOC_t0' mesurées/estimées par le système BMS après son réveil, à l'instant t0'.

Le système EMS vérifie à ce moment-là que la température prédite par le modèle électrothermique M_ET est bien celle que le système BMS mesure (par exemple à 2°C près) et que l'état de charge de la batterie qui a été prédit correspond à l'état de charge estimé par le BMS (à la précision de l'estimation près, par exemple 2%). Si les mesures correspondent aux prédictions (branches Y sur la figure 1B) ou que les mesures donnent des valeurs plus contraignantes pour le fonctionnement futur, le système EMS considère que l'action corrective AC est nécessaire et décide alors de l'action corrective AC à réaliser.

E11 : L'action corrective à réaliser peut-être un préchauffage PH de la batterie et/ou une précharge PC de la batterie à t0', antérieur à l'instant t1.

Un préchauffage PH est nécessaire si, à l'instant t1, la température de la batterie est inférieure à la température minimale T_min nécessaire pour l'exécution du profil de mission PM à cet instant t1.

Une précharge est nécessaire si, à l'instant t1, l'état de charge de la batterie est inférieur à l'état de charge minimal SOC_min nécessaire pour l'exécution du profil de mission PM à l'instant t1.

L'action corrective AC à réaliser sera d'abord avantageusement sur la température (action de préchauffage) car l'action sur la température permet souvent de corriger aussi l'état de charge. En effet comme indiqué précédemment l'état de charge minimal à partir duquel le profil de mission est réalisable est plus élevé à température plus faible. Il en ressort que si on augmente la température (via un préchauffage) pour qu'elle dépasse, à l'instant t1, la valeur minimale T_min au-dessus de laquelle le profil de mission est réalisable, on diminue alors l'état de charge minimal SOC_min.

Ensuite, le système EMS est configuré pour comparer l'état de charge de la batterie (sans précharge) à l'état de charge minimal SOC_min mis à jour (tenant compte de la nouvelle température T min). Si l'état de charge mis à jour de la batterie reste inférieur au nouvel état de charge minimal SOC_min, le système EMS commande alors également une précharge à t0'. Alternativement, il est également possible d'évaluer l'état de charge de la batterie (éventuellement par mesure via le BMS) et l'état de charge minimal SOC_min à l'issue du préchauffage, à un instant postérieur à t0' mais précédant t1, et de réaliser éventuellement une précharge s'il s'avère que l'état de charge mesuré reste inférieur à l'état de charge minimal SOC_min. Il sera cependant nécessaire de conserver une durée suffisante avant l'instant t1 pour la mise en oeuvre de la précharge.

Le préchauffage PH est commandé par le système EMS de sorte que la batterie BATT atteigne la température minimale T_min, pour laquelle le profil de mission est réalisable, au plus tard à l'instant t1 de début d'exécution de son profil de mission PM.

De même, si une précharge PC est décidée, le système EMS commande la charge de la batterie de sorte que son état de charge devienne égal à l'état de charge minimal SOC_min au plus tard à l'instant t1.

E12 : Après réveil du BMS, si la valeur théorique de température T_batt_th_t0' ou la valeur théorique d'état de charge SOC_th_t0' est finalement inférieure aux valeurs réelles acquises à l'instant t0' par le système BMS, le système EMS ne lance alors pas encore l'action corrective AC (AC t0'=NOK) et réinitialise ses valeurs de température et d'état de charge aux valeurs acquises par le système BMS à t0'.

E13 : Le système BMS est remis en veille et le processus décrit ci-dessus, allant des étapes E1 à E12 est recommencé avec les dernières valeurs qui ont été acquises par le BMS avant sa remise en veille. Le système EMS réévalue ainsi la nécessité de l'action corrective avec des données mises à jour et plus proches des valeurs réelles.

Les étapes E1 à E12 sont reprises à un instant t0", postérieur à t0' et précédant toujours l'instant t1.

En résumé, à t0, le système EMS évalue la faisabilité ou non du profil de mission PM à l'instant t1. Si ce n'est pas faisable, le système EMS identifie à quel instant t0' il faudra lancer une action corrective en préchauffage et/ou précharge sur la batterie pour que le profil de mission PM puisse être exécuté par la batterie.

La solution de l'invention selon cette première variante présente ainsi de nombreux avantages. Le système est ainsi auto-adaptatif par rapport aux mesures du système BMS. Le système BMS est réveillé à un instant t0' uniquement si un besoin d'action corrective est identifié, pour répondre au profil de mission à l'instant t1. Si le système BMS confirme les valeurs prédites, le système EMS décide de faire l'action corrective, sinon les températures et l'état de charge de l'EMS sont réinitialisés aux valeurs mesurées. Et le système BMS se remet en veille jusqu'à un nouvel instant pour réévaluer la pertinence des actions correctives.

La deuxième variante de réalisation de la séquence auxiliaire S_Aux consiste à ne pas mettre en place une action corrective, mais à déterminer à quel(s) instant(s), autre(s) que l'instant t1, le profil de mission PM pourra être exécuté par la batterie.

A partir du profil de mission PM connu (étape E1), le système EMS peut faire varier l'instant t1 dans l'application des étapes E1 à E5 afin de déterminer un ou plusieurs instants futurs pour lesquels la batterie sera fonctionnelle (SOF=1) pour l'exécution du profil de mission et un ou plusieurs instants futurs pour lesquels la batterie sera non-fonctionnelle (SOF=0) pour l'exécution du profil de mission.

Pour cela, le système EMS est configuré pour déterminer l'état de fonction SOF de la batterie en état de charge et éventuellement en température (selon les deux approches décrites à l'étape E5) et pour un ensemble d'instants t1 postérieurs à t0.

Pour la température, à titre d'exemple et en référence à la figure 3, le système EMS peut être configuré pour comparer la courbe théorique de variation de la température déterminée avec une courbe minimale de température (T_min), pour laquelle le profil de mission pourra être exécuté.

Tant que la courbe théorique de variation de la température est au-dessus de cette courbe minimale, le système EMS considère que la batterie est dans un état fonctionnel (SOF=1).

Pour l'état de charge, le système EMS peut procéder de manière identique. Tant que la courbe théorique de variation de l'état de charge est au-dessus d'une courbe minimale de variation de l'état de charge (pour laquelle le profil de mission peut être exécuté), SOC_batt_PM, le système EMS considère que la batterie est dans un état fonctionnel (SOF=1).

Le système EMS procède de la sorte pour les deux paramètres et détermine l'état fonctionnel ou non-fonctionnel de la batterie au cours du temps.

Ceci permet à l'utilisateur et/ou au système de planifier quand il serait possible d'effectuer le profil de mission sans avoir besoin d'une action corrective.

Le choix peut donc être fait d'anticiper l'exécution du profil de mission à un moment où SOF=1 avant d'entrer dans une plage temporelle où SOF=0. Le choix peut également être fait de retarder l'exécution du profil de mission pour l'effectuer à un instant où SOF=1.

Cette deuxième solution présente l'avantage de permettre une planification de la mission optimisée vis-à-vis des consommations en chaleur et en énergie liées aux actions correctives, sous réserve de disposer de flexibilité sur la planification de la mission.

**Revendications**

1. Procédé de gestion d'une batterie, mis en oeuvre à l'aide d'un système de gestion, ladite batterie étant destinée à suivre un profil de mission (PM) en puissance ou en courant débutant à partir d'un instant t1 déterminé, postérieur à un instant initial t0, **caractérisé en ce qu'**il comporte des étapes de :

    - Détermination d'une valeur théorique de l'état de charge (SOC_th) de la batterie à l'instant t1, à partir de l'état de charge initial de la batterie mesuré à l'instant t0 et de données théoriques de consommation de la batterie entre les instants t0 et t1,
    - Evaluation de la capacité de la batterie à remplir le profil de mission (PM) en état de charge audit instant t1, à partir de la valeur théorique de l'état de charge (SOC_th) de la batterie à l'instant t1, et d'une valeur d'état de charge minimale (SOC_min) à partir de laquelle le profil de mission peut être assuré,
    - Détermination d'un état de fonction (SOF) théorique de la batterie à l'instant t1, ladite batterie pouvant être dans un état fonctionnel lorsqu'elle est capable de remplir le profil de mission (PM) ou dans un état non-fonctionnel lorsqu'elle n'est pas capable de remplir le profil de mission (PM) à l'instant t1,
    - Exécution d'une séquence auxiliaire (S_Aux) pour que la batterie soit en mesure d'effectuer le profil de mission lorsque la batterie est déterminée dans un état non fonctionnel à l'instant t1,
    - La séquence auxiliaire (S_Aux) consistant à :

        ◦ Evaluer la nécessité d'une action corrective (AC) à appliquer à la batterie pour l'exécution du profil de mission,
        ◦ Déterminer l'action corrective (AC) à appliquer si celle-ci a été considérée comme nécessaire, et **en ce que** :

    - Evaluation de la nécessité de l'application d'une action corrective (AC) à apporter à la batterie, consistant à comparer une valeur théorique d'état de charge (SOC_th_ t0') de la batterie avec une valeur réelle (SOC_ t0') mesurée à un instant t0' donné antérieur audit instant t1 et postérieur à t0.

2. Procédé selon la revendication 1, **caractérisé en ce qu'**il comporte des étapes de :

    - Détermination de valeurs théoriques de la température ambiante (T_amb_th) entre les instants t0 et t1,
    - Détermination de valeurs théoriques de la température (T_batt_th) de la batterie à l'instant t1, à partir des valeurs théoriques de la température ambiante,
    - Détermination de l'état de charge minimum (SOC_min) de la batterie nécessaire à la réalisation du profil de mission, en fonction de la température de la batterie (T_batt_th).

3. Procédé selon la revendication 2, **caractérisé en ce qu'**il comporte également une étape d'évaluation de la capacité de la batterie à remplir le profil de mission (PM) en température audit instant t1, à partir de la valeur théorique de la température (T_batt_th) de la batterie à l'instant t1, et d'une valeur de température minimale (T_min) à partir de laquelle le profil de mission (PM) peut être assuré.

4. Procédé selon la revendication 2 ou 3, **caractérisé en ce qu'**évaluer la nécessité de l'application d'une action corrective (AC) à apporter à la batterie comporte la comparaison d'une valeur théorique de température (T_batt_th_t0') de la batterie avec une valeur réelle (T_batt_t0') mesurée à un instant t0' donné antérieur audit instant t1 et postérieur à l'instant t0.

5. Procédé selon l'une des revendications 2 à 4, **caractérisé en ce que** l'étape de détermination de valeurs théoriques de la température ambiante (T_amb_th) entre t0 et t1 est réalisée par acquisition de données sur un serveur distant.

6. Procédé selon la revendication 2 ou 4, **caractérisé en ce qu'**il comporte une étape de mise en veille du système de gestion entre l'instant t0 et l'instant t0'.

7. Procédé selon l'une des revendications 1 à 6, **caractérisé en ce que** l'action corrective consiste en un préchauffage (PH) de la batterie et/ou en une charge (PC) de la batterie.

8. Procédé selon la revendication 7, **caractérisé en ce qu'**il comporte une étape d'évaluation de l'application d'une action corrective de charge (PC) de la batterie, en tenant compte d'une variation, en fonction de la température, de l'état de charge minimum de la batterie nécessaire à la réalisation du profil de mission.

9. Procédé de gestion d'une batterie, mis en oeuvre à l'aide d'un système de gestion, ladite batterie étant destinée à suivre un profil de mission (PM) en puissance ou en courant débutant à partir d'un instant t1 déterminé, postérieur à un instant initial t0, **caractérisé en ce qu'**il comporte des étapes de :

   - Détermination d'une courbe théorique de l'état de charge (SOC_th) de la batterie sur une période temporelle postérieure à t0, à partir de l'état de charge initial de la batterie mesuré à l'instant t0 et des données théoriques de consommation de la batterie sur ladite période temporelle postérieure à t0,
   - Détermination d'une courbe théorique de la température (T_batt_th) de la batterie sur ladite période temporelle postérieure à t0, à partir de la température initiale de la batterie mesurée à l'instant t0 et des valeurs théoriques de la température ambiante (T_amb_th) sur ladite période temporelle postérieure à t0,
   - Evaluation de la capacité de la batterie à remplir le profil de mission (PM) en état de charge sur ladite période temporelle, par comparaison de la courbe théorique d'état de charge avec une courbe minimale d'état de charge (SOC_min) pour laquelle la batterie est apte à remplir le profil de mission, et/ou
   - Evaluation de la capacité de la batterie à remplir le profil de mission (PM) en température sur ladite période temporelle, par comparaison de la courbe théorique de la température (T_batt_th) de la batterie avec une courbe minimale de température (T_min) pour laquelle la batterie est apte à remplir le profil de mission.

10. Procédé selon la revendication 9, **caractérisé en ce qu'**il comporte une étape de détermination de la courbe minimale d'état de charge (SOC_min) pour laquelle la batterie est apte à remplir le profil de mission à partir de ladite courbe théorique de température (T_batt_th).

11. Procédé selon la revendication 9 ou 10, **caractérisé en ce que** la séquence auxiliaire (S_Aux) consiste à déterminer un ou plusieurs instants, autres que l'instant t1, auxquels la batterie sera capable de remplir le profil de mission.

12. Système de gestion d'une batterie, ladite batterie étant destinée à suivre un profil de mission (PM) en puissance ou en courant débutant à partir d'un instant t1 déterminé, postérieur à un instant initial t0, ledit système étant **caractérisé en ce qu'**il comporte :

   - Un module de détermination d'une valeur théorique de l'état de charge (SOC_th) de la batterie à l'instant t1, à partir de l'état de charge initial de la batterie mesuré à l'instant t0 et de données théoriques de consommation de la batterie entre les instants t0 et t1
   - Un module d'évaluation de la capacité de la batterie à remplir le profil de mission (PM) en état de charge audit instant t1, à partir de la valeur théorique de l'état de charge (SOC_th) de la batterie à l'instant t1, et d'une valeur d'état de charge minimale (SOC_min) à partir de laquelle le profil de mission peut être assuré,
   - Un module de détermination d'un état de fonction (SOF) théorique de la batterie à l'instant t1, ladite batterie pouvant être dans un état fonctionnel lorsqu'elle est capable de remplir le profil de mission (PM) ou dans un état non-fonctionnel lorsqu'elle n'est pas capable de remplir le profil de mission (PM) à l'instant t1,
   - Un module d'exécution d'une séquence auxiliaire (S_Aux) pour que la batterie soit en mesure d'effectuer le profil de mission lorsque la batterie est déterminée dans un état non fonctionnel à l'instant t1,
   - La séquence auxiliaire (S_Aux) consistant à :

◦ Evaluer la nécessité d'une action corrective (AC) à appliquer à la batterie pour l'exécution du profil de mission,

◦ Déterminer l'action corrective (AC) à appliquer si celle-ci a été considérée comme nécessaire, et **en ce que** :

- Pour évaluer la nécessité de l'application d'une action corrective (AC) à apporter à la batterie, le système comporte un module de comparaison d'une valeur théorique d'état de charge (SOC_th_t0') de la batterie avec une valeur réelle (SOC_t0') mesurée à un instant t0' donné antérieur audit instant t1 et postérieur à t0.

13. Système selon la revendication 12, **caractérisé en ce qu'**il comporte :

- Un module de détermination des valeurs théoriques de la température ambiante (T_amb_th) entre les instants t0 et t1,
- Un module de détermination des valeurs théoriques de la température (T_batt_th) de la batterie à l'instant t1, à partir des valeurs théoriques de la température ambiante,
- Un module de détermination de l'état de charge minimum (SOC_min) de la batterie nécessaire à la réalisation du profil de mission, en fonction de la température de la batterie (T_batt_th).

14. Système selon la revendication 13, **caractérisé en ce qu'**il comporte un module d'évaluation de la capacité de la batterie à remplir le profil de mission (PM) en température audit instant t1, à partir de la valeur théorique de la température (T_batt_th) de la batterie à l'instant t1, et d'une valeur de température minimale (T_min) à partir de laquelle le profil de mission (PM) peut être assuré.

15. Système selon la revendication 13 ou 14, **caractérisé en ce que**, pour évaluer la nécessité de l'application d'une action corrective (AC) à apporter à la batterie, le système comporte un module de comparaison d'une valeur théorique de température (T_batt_th_t0') de la batterie avec une valeur réelle (T_batt_t0') mesurée à un instant t0' donné antérieur audit instant t1 et postérieur à l'instant t0.

16. Système selon l'une des revendications 13 à 15, **caractérisé en ce que** le module de détermination de valeurs théoriques de la température ambiante (T_amb_th) entre t0 et t1 comporte des moyens d'acquisition de données sur un serveur distant.

17. Système selon la revendication 12 ou 15, **caractérisé en ce qu'**il comporte un module de mise en veille du système de gestion entre l'instant t0 et l'instant t0'.

18. Système selon l'une des revendications 11 à 17, **caractérisé en ce que** l'action corrective consiste en un préchauffage (PH) de la batterie et/ou en une charge (PC) de la batterie.

19. Système selon la revendication 18, **caractérisé en ce qu'**il comporte un module d'évaluation de l'application d'une action corrective de charge (PC) de la batterie, en tenant compte d'une variation, en fonction de la température, de l'état de charge minimum de la batterie nécessaire à la réalisation du profil de mission.

20. Système de gestion d'une batterie, ladite batterie étant destinée à suivre un profil de mission (PM) en puissance ou en courant débutant à partir d'un instant t1 déterminé, postérieur à un instant initial t0, ledit système étant **caractérisé en ce qu'**il comporte :

- Un module de détermination d'une courbe théorique de l'état de charge (SOC_th) de la batterie sur une période temporelle postérieure à t0, à partir de l'état de charge initial de la batterie mesuré à l'instant t0 et des données théoriques de consommation de la batterie sur ladite période temporelle postérieure à t0,
- Un module de détermination d'une courbe théorique de la température (T_batt_th) de la batterie sur ladite période temporelle postérieure à t0, à partir de la température initiale de la batterie mesurée à l'instant t0 et des valeurs théoriques de la température ambiante (T_amb_th) sur ladite période temporelle postérieure à t0,
- Un module d'évaluation de la capacité de la batterie à remplir le profil de mission (PM) en état de charge sur ladite période temporelle, par comparaison de la courbe théorique d'état de charge avec une courbe minimale d'état de charge (SOC_min) pour laquelle la batterie est apte à remplir le profil de mission, et/ou
- Un module d'évaluation de la capacité de la batterie à remplir le profil de mission (PM) en température sur ladite période temporelle, par comparaison de la courbe théorique de la température (T_batt_th) de la batterie avec une courbe minimale de température (T_min) pour laquelle la batterie est apte à remplir le profil de mission.

**21.** Système selon la revendication 20, **caractérisé en ce qu'**il comporte un module de détermination de la courbe minimale d'état de charge (SOC_min) pour laquelle la batterie est apte à remplir le profil de mission à partir de ladite courbe théorique de température (T_batt_th).

**22.** Système selon la revendication 20 ou 21, **caractérisé en ce que** la séquence auxiliaire (S_Aux) consiste à déterminer un ou plusieurs instants, autres que l'instant t1, auxquels la batterie sera capable de remplir le profil de mission.

**Fig. 1A**

**Fig. 1B**

E8

SOF=0 → S_Aux → AC ?

E9

BMS_t0' → T_batt_t0'
BMS_t0' → SOC_t0'

E10

SOC_t0'=SOC_th_t0'    T_batt_t0'=T_batt_th_t0'

Y    Y

AC_t0'=OK

E11

EMS → PH → BATT → T_min

EMS → PC → BATT → SOC_min

E12

t0' → AC_t0'=NOK → T_batt_t0=T_batt_t0'
→ SOC_t0=SOC_t0'

E13

t0'' → E1→ E12

*Fig. 2*

*Fig. 3*

Europäisches
Patentamt

European
Patent Office

Office européen
des brevets

# RAPPORT DE RECHERCHE EUROPEENNE

Numéro de la demande

EP 23 21 0009

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2022/189105 A1 (VOLKSWAGEN AG [DE]) 15 septembre 2022 (2022-09-15) | 1-10, 12-21 | INV. G01R31/36 |
| Y | * le document en entier * ----- | 11,22 | H02J7/00 B60L58/12 |
| Y | US 2006/208739 A1 (SCHILLER KARSTEN [DE] ET AL) 21 septembre 2006 (2006-09-21) * le document en entier * ----- | 11,22 | H01M10/48 ADD. B60L58/24 |
| A | US 2020/189554 A1 (YOO CHANG RYEOL [KR]) 18 juin 2020 (2020-06-18)  * le document en entier * ----- | 2,3,8, 10,13, 14,19,21 | H01M10/625 |
| A | US 2017/305294 A1 (HETTRICH KEVIN [US] ET AL) 26 octobre 2017 (2017-10-26) * le document en entier * ----- | 1-22 | |

DOMAINES TECHNIQUES
RECHERCHES (IPC)

G01R
H02J
B60L
H01M

Le présent rapport a été établi pour toutes les revendications

| Lieu de la recherche | Date d'achèvement de la recherche | Examinateur |
|---|---|---|
| Munich | 2 avril 2024 | Tchegho Kamdem, A |

EPO FORM 1503 03.82 (P04C02)

**ANNEXE AU RAPPORT DE RECHERCHE EUROPEENNE
RELATIF A LA DEMANDE DE BREVET EUROPEEN NO.**

**EP 23 21 0009**

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

**02-04-2024**

| Document brevet cité au rapport de recherche | Date de publication | Membre(s) de la famille de brevet(s) | Date de publication |
|---|---|---|---|
| WO 2022189105 A1 | 15-09-2022 | DE 102021202184 A1 | 08-09-2022 |
| | | EP 4301622 A1 | 10-01-2024 |
| | | WO 2022189105 A1 | 15-09-2022 |
| US 2006208739 A1 | 21-09-2006 | CN 1774643 A | 17-05-2006 |
| | | DE 10317524 A1 | 04-11-2004 |
| | | EP 1618398 A1 | 25-01-2006 |
| | | JP 4587315 B2 | 24-11-2010 |
| | | JP 2006517655 A | 27-07-2006 |
| | | US 2006208739 A1 | 21-09-2006 |
| | | WO 2004092758 A1 | 28-10-2004 |
| US 2020189554 A1 | 18-06-2020 | CN 111301218 A | 19-06-2020 |
| | | DE 102019208276 A1 | 18-06-2020 |
| | | KR 20200075118 A | 26-06-2020 |
| | | US 2020189554 A1 | 18-06-2020 |
| US 2017305294 A1 | 26-10-2017 | US 2016059733 A1 | 03-03-2016 |
| | | US 2017305294 A1 | 26-10-2017 |
| | | US 2019359083 A1 | 28-11-2019 |
| | | US 2021268936 A1 | 02-09-2021 |
| | | US 2022371473 A1 | 24-11-2022 |
| | | US 2023331120 A1 | 19-10-2023 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2022189105 A1